## Europäisches Patentamt

## European Patent Office

## Office européen des brevets

(11) Veröffentlichungsnummer: **0 106 119**
**B1**

(12) ## EUROPÄISCHE PATENTSCHRIFT

(45) Veröffentlichungstag der Patentschrift:
06.08.86

(21) Anmeldenummer: 83108827.3

(22) Anmeldetag: 07.09.83

(51) Int. Cl.⁴: **H 03 K 17/94,** H 05 B 37/00,
H 02 J 7/00

(54) Fernbedienbarer Schalter.

(30) Priorität: 20.09.82 DE 3234763

(43) Veröffentlichungstag der Anmeldung:
25.04.84 Patentblatt 84/17

(45) Bekanntmachung des Hinweises auf die Patenterteilung:
06.08.86 Patentblatt 86/32

(84) Benannte Vertragsstaaten:
AT CH DE IT LI SE

(56) Entgegenhaltungen:
DE - A - 2 437 339
DE - A - 3 018 026
DE - A - 3 111 753
GB - A - 2 046 538
US - A - 4 270 058
US - A - 4 274 045

ELECTRONICS, Band 44, Nr. 1, 4. Januar 1971 D. JEUTTER "Battery discharge triggers alarm and shuts off supply", Seite 68

(73) Patentinhaber: Siemens Aktiengesellschaft Berlin und München, Wittelsbacherplatz 2, D-8000 München 2 (DE)

(72) Erfinder: Rösch, Helmut, Schulterbreitenstrasse 6, D-8411 Ellsbrunn (DE)

**Beschreibung**

Die Erfindung bezieht sich auf einen fernbedienbaren Schalter, dessen Lastteil von einem elektronischen Steuerteil geschaltet wird, das über einen Sensor für ein Feld seine Befehle empfängt, dessen Anschlüsse für den Lastteil das Steuerteil speisen, indem im Ruhezustand, das heisst bei geöffnetem Lastteil, ein Speicher aufgeladen wird, der im eingeschalteten Zustand des Lastteils die Energie für das Steuerteil liefert.

Bei einem derartigen bekannten Schalter (DE-A-2437339) kann ein Verbraucher akustisch über ein Mikrofon gesteuert werden. Da der Speicher zur Versorgung der Steuereinrichtung im Ruhezustand aufgeladen wird, kann sich bei eingeschaltetem Verbraucher der Speicher so weit entladen, dass die Steuereinrichtung nicht mehr betätigt werden kann.

Zum leitungslosen Schalten und Dimmen von Verbrauchern hat sich Infrarotlicht als vorteilhaft erwiesen. Sowohl Sender und Empfänger für Infrarotlicht als auch solche für Ultraschall benötigen jedoch eine Versorgungsspannung, die üblicherweise beim ortsveränderlichen Sender aus einer Batterie kommt. Bei fest installierten Geräten kann in vielen Fällen an einer Steckdose angeschlossen werden, um die Energie dem Netz zu entnehmen. Wünschenswert ist jedoch auch vielfach, die Geräte so auszubilden, dass der Empfänger in üblichen Installationsdosen untergebracht werden kann.

Bei allen Geräten, die dafür bestimmt sind, in einer Installationsdose untergebracht zu werden, in die zum Zweck der Verwirklichung der normalen Ausschaltung (Schalterart 1 nach DIN 49290) lediglich zwei Leiter, nämlich der Netzaussenleiter und der Schaltleiter, nicht jedoch der Mittelleiter geführt sind, treten jedoch Spannungs-Versorgungsschwierigkeiten auf, die üblicherweise nur durch Nachinstallation des Mittelleiters behoben werden können.

Bei elektronischen Zeitschaltern, also Geräten, die automatisch nach einer vorbestimmten Zeit wieder ausschalten, gibt es einen Vorschlag mit älterem Zeitrang, wonach mit nur zwei Anschlüssen sowohl das Lastteil als auch zugleich das Steuerteil gespeist wird, indem im Ruhezustand ein Speicher aufgeladen wird, der im eingeschalteten Zustand des Lastteils die Energie für das Steuerteil liefert (DE: P 3111753.8, Veröffentlichungstag 7.10.82). Auch eine solche Ausführung eignet sich jedoch nicht, wenn nach einer vom Bedienenden frei zu wählenden längeren Zeitspanne der Schalter erst wieder ausgeschaltet werden soll, da der Speicher dann bereits erschöpft sein kann. Die Anmeldung mit älterem Zeitrang bezieht sich auf konventionell zu bedienende Zeitschalter und nicht auf Fernschalter.

Der Erfindung liegt die Aufgabe zugrunde, einen fernbedienbaren Schalter zu entwickeln, dessen Anschlüsse für das Lastteil zugleich das Steuerteil speisen, der lediglich mit zwei Anschlüssen auskommen kann und der bedienbar bleibt.

Die Lösung der geschilderten Aufgabe besteht nach der Erfindung darin, dass dem Speicher eine Spannungsüberwachungseinrichtung zugeordnet ist, die darauf ausgelegt ist, bei Absinken der Spannung unter einen Grenzwert – oberhalb der Spannung, die noch zum sicheren Betätigen des Steuerteils ausreicht – das Lastteil auszuschalten, wodurch eine Last abgeschaltet und der Speicher über die Anschlüsse für das Lastteil wieder mit Ladespannung versorgt wird.

Eine solche Konzeption ermöglicht es also, einen fernbedienbaren Schalter zu bauen, der nur mit zwei Anschlüssen auskommt. Insbesondere kann der Sensor für Infrarotlicht empfindlich ausgelegt werden. Im Prinzip könnten jedoch auch andere Felder, wie Ultraschall, genutzt werden.

Insbesondere kann die Spannungsüberwachungseinrichtung parallel zum Speicher angeschlossen werden und ihr Steuerausgang auf das Lastteil wirken.

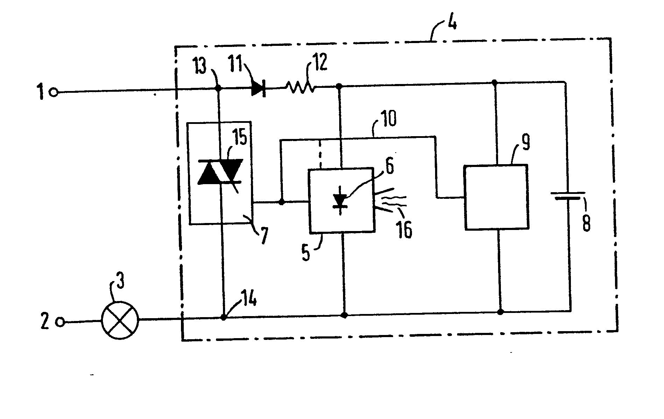

Die Erfindung soll nun anhand eines in der Zeichnung grob schematisch wiedergegebenen Ausführungsbeispiels näher erläutert werden:

Zwischen einem Aussenleiter 1 und einem geerdeten Mittelleiter 2 kann ein Verbraucher 3 durch den fernbedienbaren Schalter 4 eingeschaltet werden. Ein Steuerteil 5 mit einem Sensor 6 für ein Feld 16, im Ausführungsbeispiel ein Sensor für Infrarotlicht, steuert ein Lastteil 7 mit einem Schaltglied, z. B. ein Lastventil 15, beispielsweise einen Thyristor. Ein Speicher 8 wird bei nichtleitendem Lastventil 15 vom Netz aufgeladen, da in diesem Fall annähernd die gesamte Netzspannung zwischen den Punkten 13 und 14 liegt. Als Speicher eignet sich insbesondere ein bekannter Langzeitspeicher. In der Zeichnung ist er durch einen Akkumulator veranschaulicht. Parallel zum Speicher 8 ist eine Spannungsüberwachungseinrichtung 9 angeschlossen, deren Steuerausgang 10 ebenso wie der Steuerausgang des Steuerteils 5 mit dem Sensor 6 auf das Lastteil 7 wirkt.

Um den Speicher 8, beispielsweise ein Akkumulator, aus einem Wechselstromnetz aufzuladen, ist ein Gleichrichter 11 in den Ladekreis eingeschaltet. Hierzu liegt zur Begrenzung des Ladestroms ein Widerstand 12 in Reihe.

Die Einrichtung zur Spannungsüberwachung 9 ist darauf ausgelegt, bei Absinken der Spannung unter einen Grenzwert, der oberhalb der Spannung liegt, die zum sicheren Betätigen des Lastteils 7 und somit des Lastventils 15 gerade noch ausreicht, das Lastteil auszuschalten, wodurch eine Last 3 abgeschaltet wird. Bei abgeschalteter Last, also bei nichtleitendem Lastventil 15, sind die Anschlüsse 1, 2 für das Lastteil wieder am Speicher 8 wirksam angeschaltet.

Wenn der Sensor 6 des Steuerteils 5 des fernbedienbaren Schalters 4 mittels Infrarotlicht das Einschaltsignal erhält, steuert er das Lastventil 15 leitend. Die Spannungsversorgung für das Steuerteil 5 und die Spannungsüberwachung 9 übernimmt dann der Speicher 8. Wenn die Einrichtung für die Spannungsüberwachung 9 feststellt, dass die Spannung des Speichers 8 unter den Grenzwert absinkt, gibt die Spannungsüberwachung 9 an das Lastteil 7 direkt oder über das Steuerteil 5 ein Signal ab, das dazu führt, dass das Lastventil 15 gesperrt wird. Bei abgeschaltetem Verbraucher 3 kann sich dann der Speicher 8 wieder aufladen. Diese selbsttätige Abschaltung kann beispielsweise erst nach einer Betriebsdauer von mehr als 10 Stunden erfolgen, so dass in der Praxis zuvor willentlich ausgeschaltet worden sein wird. Es ist jedoch sichergestellt, dass auch bei extrem langer Betriebsdauer das Wiedereinschalten und Ausschalten durch eine Bedienungsperson gewährleistet ist.

**Patentansprüche**

1. Fernbedienbarer Schalter (4), dessen Lastteil von einem elektronischen Steuerteil geschaltet wird, das über einen Sensor für ein Feld (16) seine Befehle empfängt, dessen Anschlüsse (1, 2) für den Lastteil das Steuerteil speisen, indem im Ruhezustand, das heisst bei geöffnetem Lastteil, ein Speicher (8) aufgeladen wird, der im eingeschalteten Zustand des Lastteils die Energie für das Steuerteil liefert, dadurch gekennzeichnet, dass dem Speicher (8) eine Spannungsüberwachungseinrichtung (9) zugeordnet ist, die darauf ausgelegt ist, bei Absinken der Spannung unter einen Grenzwert – oberhalb der Spannung, die noch zum sicheren Betätigen des Steuerteils ausreicht – das Lastteil auszuschalten, wodurch eine Last (3) abgeschaltet und der Speicher (8) über die Anschlüsse (1, 2) für das Lastteil wieder mit Ladespannung versorgt wird.

2. Fernbedienbarer Schalter nach Anspruch 1, dadurch gekennzeichnet, dass der Sensor (6) für Infrarotlicht empfindlich ausgelegt ist.

3. Fernbedienbarer Schalter nach Anspruch 1, dadurch gekennzeichnet, dass die Spannungsüberwachung (9) parallel zum Speicher (8) angeschlossen ist und dass ihr Steuerausgang (10) auf das Lastteil (7) direkt oder über das Steuerteil (5) einwirkt.

**Claims**

1. A remotely-operable switch (4) whose load component is switched by an electronic control component which receives its commands via a sensor for a field (16), and whose terminals (1, 2) for the load component feed the control component such that in the rest state when the load component is open a store (8) is charged, which store supplies the energy for the control component when the load component is connected, characterised in that the store (8) is assigned a voltage-monitoring device (9) designed to disconnect the load component when the voltage falls below a limit value – above the voltage adequate to ensure a reliable operation of the control component – whereby a load (3) is disconnected and the store (8) is resupplied with charging voltage via the terminals (1, 2) for the load component.

2. A remotely-operable switch as claimed in claim 1, characterised in that the sensor (6) is sensitive to infra-red light.

3. A remotely-operable switch as claimed in claim 1, characterised in that the voltage-monitoring device (9) is connected parallel to the store (8) and that its control output (10) acts on the load component (7) either directly or via the control component (5).

**Revendications**

1. Commutateur (4) à commande à distance, dont la partie constituant la charge est commutable par une partie électronique constituant la commande, recevant ses instructions par l'intermédiaire d'un capteur pour un champ (16), et dont les bornes (1, 2) pour la partie constituant la charge alimentant la partie constituant la commande, en faisant en sorte qu'à l'état de repos, c'est-à-dire à l'état ouvert de la partie constituant la charge, un dispositif accumulateur d'énergie soit chargé et fournisse, à l'état branché de la partie constituant la charge, l'énergie pour la partie constituant la commande, caractérisé par le fait qu'au dispositif accumulateur d'énergie (8) est associé un dispositif de contrôle de la tension (9), qui est réalisé de manière que pour la chute de la tension en-dessous d'une valeur limite – au-dessus de la tension qui est encore suffisante pour la commande sûre de la partie constituant la commande – la partie constituant la charge est débranchée, grâce à quoi une charge (3) est débranchée et le dispositif accumulateur d'énergie (8) est à nouveau alimenté en tension de charge par l'intermédiaire des bornes (1, 2) pour la partie constituant la charge.

2. Commutateur à commande à distance selon la revendication 1, caractérisé par le fait que le capteur (6) est réalisé de manière à être sensible à la lumière infrarouge.

3. Commutateur à commande à distance selon la revendication 1, caractérisé par le fait que le contrôle de la tension (9) est monté en parallèle sur le dispositif accumulateur d'énergie (8), et que sa sortie de commande (10) agit directement sur la partie constituant la charge (7) ou par l'intermédiaire de la partie constituant la commande (5).